(19)

Europäisches
Patentamt
European
Patent Office
Office européen
des brevets

(11)    EP 2 803 137 B1

(12)    **EUROPEAN PATENT SPECIFICATION**

(45) Date of publication and mention
of the grant of the patent:
**23.11.2016 Bulletin 2016/47**

(51) Int Cl.:
*H03H 17/02* [(2006.01)]      *H03H 17/06* [(2006.01)]
*H04R 3/04* [(2006.01)]

(21) Application number: **13735847.9**

(86) International application number:
**PCT/US2013/020740**

(22) Date of filing: **09.01.2013**

(87) International publication number:
**WO 2013/106370 (18.07.2013 Gazette 2013/29)**

(54) **MULTI-RATE FILTER SYSTEM**

MULTI-RATE-FILTERSYSTEM

SYSTÈME DE FILTRAGE MULTI-DÉBITS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **10.01.2012   US 201261584855 P
12.06.2012   US 201261658560 P**

(43) Date of publication of application:
**19.11.2014   Bulletin 2014/47**

(73) Proprietor: **Cirrus Logic International
Semiconductor Limited
EH11 2QB (GB)**

(72) Inventors:
• **LINDAHL, Erik
11727 Stockholm (SE)**
• **LINDBLOM, Ludvig
58333 Linköping (SE)**
• **RISBERG, Pär Gunnars
S-17166 Solna (SE)**
• **TOTH, Landy
Newton, Pennsylvania 18940 (US)**

(74) Representative: **O'Connell, David Christopher
Haseltine Lake LLP
Redcliff Quay
120 Redcliff Street
Bristol BS1 6HU (GB)**

(56) References cited:
**US-A1- 2006 109 941      US-A1- 2006 109 941
US-A1- 2006 159 283      US-B1- 7 376 688
US-B2- 7 321 913         US-B2- 7 757 557**

**Description**

**BACKGROUND**

**Technical Field**

The present disclosure is directed to digital filters and particularly to multi-rate digital filters for audio signal processing.

**Background**

Mobile technologies and consumer electronic devices (CED) continue to expand in use and scope throughout the world. In parallel with continued proliferation, there is rapid technical advance of device hardware and components, leading to increased computing capability and incorporation of new peripherals onboard a device along with reductions in device size, power consumption, etc.

Many CEDs rely on signal processing with digital filters to perform a wide range of functions on the device (e.g. audio/video signal processing, sensor signal processing, voice recognition, etc.).

A feed forward or a feedback digital filter typically includes a number of equally spaced taps with each tap separated by a delay line and multiplied by a filter coefficient. The filter coefficients determine the impulse response of the filter.

A feed forward digital filter for use on a signal with broad spectral content (e.g. a signal with several orders of magnitude of bandwidth), may often require excessive sampling of the signal, particularly as related to the low frequency content thereof. In addition, the resulting complexity of the filter may be challenging to implement in resource constrained devices, as it may consume additional hardware and software resources with increased bandwidth coverage and complexity.

As the size and complexity of the filter are increased to accommodate additional signal spectrum, it becomes more challenging to tune the filter coefficients to produce the desired frequency response. In addition, applying adaptive, learning and/or optimization algorithms to the real-time adjustment of filter coefficients is much more challenging to implement as the size and complexity of the digital filter is increased.

The document US2006/0109941 discloses a multi-rate filter system according to the prior art.

SUMMARY

One objective of the present disclosure is to provide a filter system.

Another objective is to provide a filter system for enhancing audio output from a consumer electronics device.

The above objectives are wholly or partially met by devices, systems, and methods described herein. In particular, features and aspects of the present disclosure are set forth in the appended claims, following description, and the annexed drawings.

According to a first aspect there is provided, a multi-rate filter system including an input channel configured to receive an input signal, an output channel configured to output a filtered signal, a cascade of multi-rate filter blocks coupled between the input channel and the output channel. At least one of the multi-rate filter blocks after a first multi-rate filter block in the cascade includes a bandselector comprising a bandselector input, a highpass bandselector output, a lowpass bandselector output connected to a subsequent multi-rate filter block, and a downsampler connected between the bandselector input and the lowpass bandselector output, a signal processing block coupled to the highpass bandselector output, the signal processing block comprising a linear filter component, and a bandcombiner connected to the signal processing block, the bandcombiner comprising two bandcombiner inputs, a bandcombiner output, and an upsampler, the first bandcombiner input connected to the signal processing block, the second bandcombiner input connected to a subsequent multi-rate filter block, and the bandcombiner output connected to a prior multi-rate filter block, the upsampler connected between the bandcombiner inputs and the bandcombiner output.

In aspects, the linear filter component may be selected from a group including a finite impulse response (FIR) filter, an infinite impulse response (IIR) filter, a Kalman filter, a neural network, a fuzzy logic filter, a lattice wave filter, a linear phase filter, a near linear phase filter, and combinations thereof. The linear filter component may include reconfigurable filter parameters in accordance with the present disclosure.

In aspects, the signal processing block may include a nonlinear filter component in accordance with the present disclosure connected to the linear filter component. Some non-limiting examples of a suitable nonlinear filter component include a compressor, a polynomial, a limiter, and combinations thereof.

In aspects, one or more multi-rate filter blocks may include an observer in accordance with the present disclosure configured to output an observer signal, the observer connected to the signal processing block between the highpass bandselector output and the first bandcombiner input. The observer may include a power monitor. One or more filter components (e.g the nonlinear filter component, the linear filter component) may be configured to respond to the observer signal (e.g. by changing a filter gain, alter a parameter, attack, release, etc.).

In aspects, the multi-rate filter system may include a nonlinear functional block (NLFB) including an NLFB input and an NLFB output. The NLFB input may be connected to the bandcombiner output of a first multi-rate filter block and the NLFB output may be connected to the bandcombiner input of a second second multi-rate filter block. The nonlinear function block may include a psychoacoustic function.

In aspects, the downsampler may be an m:1 downsampler, where m is a sample rate, and the upsampler may be a 1:k upsampler, where k is a sample rate. The sample rates m and k may be equal. The sample rates m and/or k may be less than or equal to 2, less than or equal to 1.5, less than or equal to 1.33, or less than or equal to 1.25.

In aspects, the multi-rate filter blocks may span an audio signal bandwidth.

In aspects, the bandselector may include a low pass filter connected between the bandselector input and the bandselector lowpass output, and a high pass filter connected between the bandselector input and the bandselector highpass output. A complimentary filter pair may be formed by the low pass filter and high pass filter.

In aspects, the bandcombiner may include a summer connected to the bandcombiner inputs and the upsampler and/or a low pass filter connected between the upsampler and the bandcombiner output.

In aspects, the multi-rate filter system may include a control channel configured to receive a control signal, with at least one multi-rate filter block being connected to the control channel.

In aspects, the linear filter component and/or the nonlinear filter component may be configured to respond to the control signal.

According to another aspect there is provided, use of a multi-rate filter system in accordance with the present disclosure, in a consumer electronics device.

According to yet another aspect there is provided, use of a multi-rate filter system in accordance with the present disclosure, to process an audio signal.

According to aspects there is provided, a method for filtering a signal, the method including, processing an input signal with a plurality of multi-rate filter blocks, the processing of at least one multi-rate filter block including, selecting a high frequency band and a low frequency band of a received signal, downsampling the low frequency band of the received signal to produce a downsampled signal, providing the downsampled signal to a subsequent multi-rate filter block, processing the high frequency band of the received signal with a linear filter component to form a linear filtered signal, combining the filtered signal with a further filtered signal from the subsequent multi-rate filter block to form a filtered output signal, and upsampling the filtered output signal to form an increased rate signal.

In aspects, the method may include processing at least one increased rate signal with a nonlinear functional block (NLFB) to form a nonlinear processed signal, providing the nonlinear processed signal to a prior multi-rate filter block, and/or providing the increased rate signal to a prior multi-rate filter block.

Some suitable non-limiting examples of the linear filter component include a finite impulse response (FIR) filter, an infinite impulse response (IIR) filter, a Kalman filter, a neural network, a fuzzy logic filter, and combinations thereof.

Suitable non-limiting examples of the nonlinear filter component include a compressor, a polynomial, a limiter, and combination thereof.

According to aspects there is provided a method for matching a multi-rate filter system in accordance with the present disclosure to a predetermined wideband filter, the method including, assigning the number of multi-rate filter blocks in the multi-rate filter system, calculating an initial guess for one or more of the multi-rate filter blocks, optimizing the multi-rate filter blocks towards the wideband filter to form one or more updated multi-rate filter blocks; and constructing a matched multi-rate filter system from the updated multi-rate filter blocks.

The step of calculating may be performed via any method in accordance with the present disclosure. In one aspect, the step of calculating may be performed using a Parks-McClellan algorithm.

The step of optimizing may be performed on one or more bandselectors and one or more bandcombiners included in the multi-rate filter system, and separately on one or more of the signal processing blocks included in the multi-rate filter system.

The method may include adding a nonlinear function block to one or more of the multi-rate filter blocks and optionally configuring the nonlinear function block to match a psychoacoustic function, a compressor, a limiter, or the like.

## BRIEF DESCRIPTION OF THE DRAWINGS

Fig. 1a shows a schematic of a multi-rate filter system in accordance with the present disclosure.

Figs. 2a-e show diagrams of processing blocks associated with a multi-rate filter system in accordance with the present disclosure.

Fig. 3 shows a nonlinear functional block for implementing an audio enhancement algorithm with a multi-rate filter system in accordance with the present disclosure.

Fig. 4 shows a feedback system for use with a multi-rate filter system in accordance with the present disclosure.

Fig. 5 shows an example of a multi-rate filter system including a nonlinear functional block in accordance with the present disclosure.

Fig. 6a-b show examples of frequency bands associated with a multi-rate filter system in accordance with the present disclosure.

Fig. 7a-b show a method for optimizing a multi-rate filter in accordance with the present disclosure and a resulting error spectral response.

## DETAILED DESCRIPTION

Particular embodiments of the present disclosure are described hereinbelow with reference to the accompanying drawings; however, the disclosed embodiments are merely examples of the disclosure and may be embodied in various forms. Well-known functions or constructions are not described in detail to avoid obscuring the present disclosure in unnecessary detail. Therefore, specific structural and functional details disclosed herein are not to be interpreted as limiting, but merely as a basis for the claims and as a representative basis for teaching one skilled in the art to variously employ the present disclosure in virtually any appropriately detailed structure. Like reference numerals may refer to similar or identical elements throughout the description of the figures.

By consumer electronic device is meant a cellular phone (e.g. a smartphone), a tablet computer, a laptop computer, a portable media player, a television, a portable gaming device, a gaming console, a gaming controller, a remote control, an appliance (e.g. a toaster, a refrigerator, a bread maker, a microwave, a vacuum cleaner, etc.) a power tool (a drill, a blender, etc.), a robot (e.g. an autonomous cleaning robot, a care giving robot, etc.), a toy (e.g. a doll, a figurine, a construction set, a tractor, etc.), a greeting card, a home entertainment system, an active loudspeaker, a sound bar, etc.

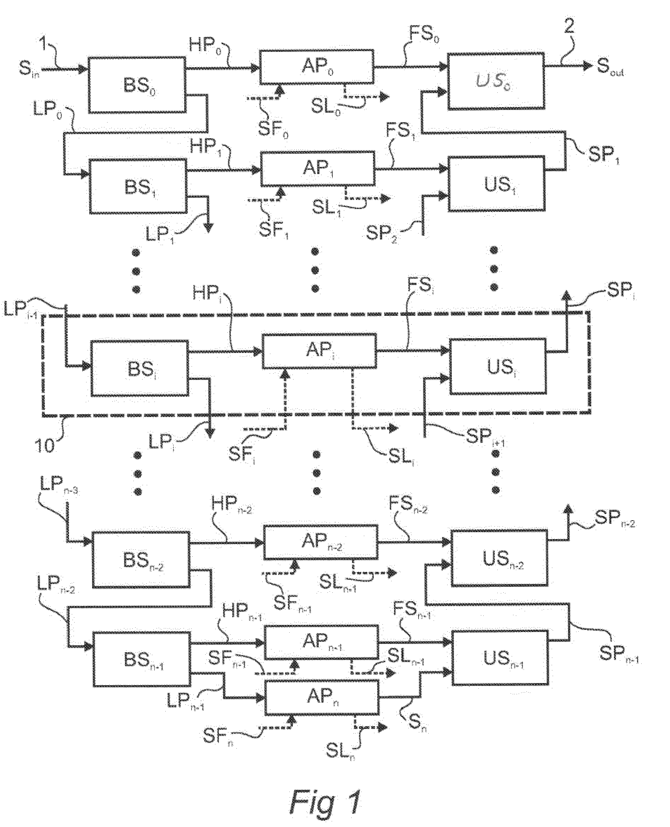

Fig. 1 shows a multi-rate filter system in accordance with the present disclosure. The filter system includes an input channel 1 configured to accept an input signal $S_{in}$ from an external source (e.g. a processor, an signal streaming device, an audio feedback device, a wireless transceiver, an ADC, an audio decoder circuit, a DSP, etc.), and an output channel 2 for outputting a filtered signal $S_{out}$, and a plurality of multi-rate filter blocks 10.

At least one of the multi-rate filter blocks 10 includes a bandselector $BS_i$ configured to accept a signal from the input channel 1 of a previous multi-rate filter block 10 and to produce a highpass bandselector output signal $HP_i$, and a lowpass bandselector output signal $LP_i$ to be delivered to a subsequent multi-rate filter block or to a subband processing block (e.g. a signal processing block covering the lowest signal band of interest). The multi-rate filter block 10 may also include a signal processing block $AP_i$ connected to the bandselector $BS_i$. The signal processing block $AP_i$ may include a linear filter component (e.g. a finite impulse response (FIR) filter, an infinite impulse response (IIR) filter, a Kalman filter, a neural network, a fuzzy logic filter, a butterworth filter, a lattice wave filter, etc.). The multi-rate filter block 10 may also include a bandcombiner connected to the signal processing block $AP_i$. The bandcombiner $US_i$ may include two bandcombiner inputs, a bandcombiner output, and an upsampler.

The first bandcombiner input $FS_i$ may be connected to the signal processing block $AP_i$, the second bandcombiner input $SP_{i+i}$ may be connected to a subsequent multi-rate filter block, and the bandcombiner output $SP_i$ connected to a prior multi-rate filter block. The upsampler may be connected between the bandcombiner inputs $FS_i$, $SP_{i+1}$ and the bandcombiner output $SP_i$.

The bandselector $BS_i$ may be configured to isolate a signal band to produce the bandselector highpass output $HP_i$. This function may be achieved with a high pass filter. The band selector may also be configured to produce a lowpass bandselector output $LP_i$ at a resampled rate. This function may be achieved using a downsampler (e.g. an m:1 downsampler where m is a sample rate, a 8:1, 6:1, 4:1, 3:1, 2:1, 1.5:1, 1.25:1, downsampler, an adaptive sampling unit, an asynchronous sample rate converter, etc.), optionally in conjunction with a low pass filter. The highpass filter and the lowpass filter included in the bandselector $BS_i$ may be complimentary filter pairs (i.e. so as to provide perfectly matched filters and to simplify the filter design). The downsampler associated with each bandselector $BS_i$ may be configured to perform a different change in sampling rate, from the other downsamplers in the system, it may be similar, etc. (i.e. each downsampler may have a unique value m, m may be the same for a plurality or all of the downsamplers, etc.).

Each signal processing block $AP_i$ may be configured so as to operate at an associated sample rate. The sample rate may be determined by the associated downsampler or a filter block controller (not explicitly shown). A filter block controller may be configured to set filter parameters for each of the components of the filter system upon startup, upon firmware update, etc. Each signal processing block $AP_i$ may be configured to process the associated highpass band-selector output signal $HP_i$ with a predetermined degree of precision (i.e. bit count). In one non-limiting example, signal processing blocks $AP_i$ associated with progressively lower frequency bands, may be configured to analyze the associated signals with increasing degree of precision. The associated downsampler may be configured to increase the precision of the output generated therefrom by an amount related to the downsampling parameter. Such changes in precision may be advantageous to compromise between delay and the number of filter blocks 10 in the filter system.

In aspects, the signal processing block $AP_i$ may include a linear filter component (e.g. a finite impulse response (FIR) filter, an infinite impulse response (IIR) filter, a Kalman filter, a neural network, a fuzzy logic filter, a butterworth filter, etc.), for modifying the signal content in the selected band. In aspects, the signal processing block $APi$ may include a nonlinear filter component $nLB_i$ (a clipper, a compressor, a limiter, an integrator, a multiplier, a convolution, a rectifier, a piecewise linear shaping function, a nonlinear transfer function, and/or an asymmetric polynomial function to calculate at least a portion of the second enhanced signal, etc.). The linear and/or nonlinear filter components may be configured to process the signal content within the selected band. The nonlinear filter may be configured to generate signal content out of band. The acceptable out of band range may be determined by the bandwidth associated with the band and the sample rate associated with the band.

In aspects, the bandcombiner $US_i$ may be connected to the signal processing block $AP_i$ and the bandcombiner output $SP_{i+1}$ from a subsequent multi-rate filter block. The bandcombiner $US_i$ may include a summer to combine the inputs signals thereto, an upsampler (e.g. an 1:k upsampler where k is a sample rate, a 1:1, 1:1.5, 1:1.2, 1:8, 1:6, 1:4 upsampler, an adaptive sampling unit, an asynchronous sample rate converter, etc.), to upsample the combined signals to form the bandcombiner output signal $SP_i$. In aspects, the bandcombiner $USi$ may include a low pass filter connected to the upsampler, to prevent imaging of the bandcombiner output signal $SP_i$.

The band limits and the sample rates associated with each multi-rate filter block may be configured based upon the desired processing characteristics thereof. In a non-limiting example, wherein the multi-rate filter block 10 includes only linear signal processing components, the sample rate need only be 2x the associated upper limit of the associated band. Additional headroom may be provided by adjusting the cutoff frequency of the low pass filter in the associated bandselector $BS_i$. In a non-limiting example where the multi-rate filter block 10 includes nonlinear processing element, the ratio of the sample rate to the upper limit of the associated band may be greater than 2x, may be adaptively changed during processing, etc. In aspects, the multi-rate filter block 10 may include a look ahead buffer suitable for predicting changes in the signal and adaptively compensating the gain of a nonlinear filter block (e.g. attack and release of a compressor, a limiter, etc.), altering the relationships between the upper limit of the associated band and the sample rate, combinations thereof, or the like.

In aspects, the downsample rates m and the upsample rates k of the multi-rate filter blocks 10 may be equal to each other. In a non-limiting example, the downsample and upsample rates are equal to 2 (e.g. thus segmenting the signal spectrum into octave bands).

In aspects, the multi-rate filter may include an output stage (e.g. just prior to the output channel 2, connected to the output channel 2, included in the bandcombiner $US_0$). In aspects, the output stage may include an audio amplifier (e.g. a class AB, class D amplifier, etc.), a crossover (e.g. a digital cross over, an active cross over, a passive crossover, etc.), and/or an audio enhancement system (AES) including a psychoacoustic function each in accordance with the present disclosure.

In aspects, the multi-rate filter system or portion thereof (e.g. a component, a down-sampler, an up-sampler, a processing block, etc.), may be configured with an overall signal delay (i.e. the delay between the input signal 1 and the output signal 2). In aspects, the multi-rate filter system may be configured to provide an overall linear phase relationship between the input signal 1 and the output signal 2. As such, the multi-rate filter system may include one or more linear phase filters to provide the associated relationship. The multi-rate filter system may include one or more near linear phase filters, configured in order to provide a nearly linear phase relationship between the input thereto and the output therefrom. In aspects, the multi-rate filter system may be configured with a maximal delay below a predetermined value (e.g. less than 45ms, less than 22ms, less than 10ms, etc.).

In aspects, the multi-rate filter may be included in a consumer electronics device. The multi-rate filter may be configured to compensate for one or more acoustic characteristics of the consumer electronics device. Some non-limiting examples of acoustic characteristics which may be compensated for by the multi-rate filter factors such as the loudspeaker design (speaker size, internal speaker elements, material selection, placement, mounting, covers, available back volume, etc.), device form factor, internal component placement, screen real-estate and material makeup, case material selection, hardware layout, and assembly considerations amongst others.

In aspects, the multi-rate filter system may be configured to compensate for one or more properties of a sound producing device such a film speaker. Some non-limiting examples of speaker properties to be compensated for include nonlinear transduction effects, memory effects, rate dependent hysteresis, mode breakup, large signal nonlinearities, limited bass response, environmental dependence (e.g. temperature, humidity, pressure differences, etc.), combinations thereof, and the like.

In aspects, the signal processing block $AP_i$ may include such functionality as FIR filtering, IIR filtering, warped FIR filtering, transducer artifact removal, disturbance rejection, user specific acoustic enhancements, user safety functions, emotive algorithms, psychoacoustic enhancement, signal shaping, single or multi-band compression, expanders or limiters, watermark superposition, spectral contrast enhancement, spectral widening, frequency masking, quantization noise removal, power supply rejection, crossovers, equalization, amplification, driver range extenders, power optimization, linear or non-linear feedback or feed-forward control systems, and the like. The signal processing block $AP_i$ may include one or more of the above functions, either independently or in combination. One or more of the included functions may be configured to depend on one or more pre-configurable and/or reconfigurable parameters. The functions may be combined to form an equivalent linear filter component and nonlinear filter component.

In aspects, the multi-rate filter system (e.g. via the collective combination of the signal processing blocks $AP_0$ to $AP_n$) may be configured to provide echo cancellation, environmental artifact correction, reverb reduction, beam forming, auto calibration, stereo widening, virtual surround sound, virtual center speaker, virtual sub-woofer (by digital bass enhancement techniques), noise suppression, sound effects, or the like. One or more of the included functions may be configured to depend on one or more of the parameters.

In aspects, the multi-rate filter system (e.g. via the collective combination of the signal processing blocks $AP_0$ to $AP_n$) may be configured to impose ambient sound effects onto an audio signal 801, such as by transforming an audio input signal conveyed via the input channel 1 with an ambient environmental characteristic (e.g. adjusting reverb, echo, etc.) and/or superimposing ambient sound effects onto the audio input signal akin to an environmental setting (e.g. a live event, an outdoor setting, a concert hall, a church, a club, a jungle, a shopping mall, a conference setting, an elevator, a conflict zone, an airplane cockpit, a department store radio network, etc.).

In aspects, the ambient sound effects may be configured so as to include specific information about a user, such as name, preferences, etc. The ambient sound effects may be used to securely superimpose personalized information (e.g. greetings, product specific information, directions, watermarks, handshakes, etc.) into an audio stream.

In aspects wherein the signal processing blocks $AP_i$ include associated linear filter components, the linear filter component may be optimized to enhanced the audio performance of a consumer electronics device into which it is implemented. A non-limiting example of a method for enhancing audio performance of a consumer electronic device (CED) includes placing the consumer electronic device including an audio signal source, one or more transducers, an integrated loudspeaker assembly, and a multi-rate filter system in accordance with the present disclosure into an acoustic test chamber with a plurality of audio sensors (e.g. microphones) spatially and optionally strategically arranged within the acoustic test chamber and/or on or within the CED (e.g. a microphone on a handset CED). A range of test audio signals (e.g. impulse signals, frequency sweeps, music clips, pseudo-random data streams, etc.) may be played on the consumer electronic device and monitored with the audio sensors. In an initial test, the multi-rate filter system may be substantially configured with one or more pass band linear filters (a null state whereby the multi-rate filter system is configured so as to not substantially affect the audio signal pathway through the CED).

In aspects, the signal processing block $AP_i$ transfer functions may be parametrically configured to compensate for the acoustic signature of the CED. One, non-limiting approach for calculating the transfer function(s) from the acoustic signature of the CED is to implement a time domain inverse finite impulse response (FIR) filter based upon the estimated acoustic signature of the CED. This may be implemented by performing one or more convolutions of the transfer functions with the acoustic responses of the CED to the audio input signals. An averaging algorithm may be used to optimize the transfer function(s) from the outputs measured across multiple sources and/or multiple test audio signals.

In one non-limiting example, the compensation transfer function may be calculated from a least squares (LS) time-domain filter design approach. If $c(n)$ is the system response to be corrected (such as the output of an impulse response test) and a compensating filter is denoted as $h(n)$, then one can construct $C$, the convolution matrix of $c(n)$, as outlined in equation 1:

$$C = \begin{bmatrix} c(0) & & 0 \\ \vdots & \ddots & \vdots \\ c(N_c - 1) & \ddots & c(0) \\ \vdots & \ddots & \vdots \\ 0 & & c(N_c - 1) \end{bmatrix} \qquad \text{[equation 1]}$$

where $N_c$ is the length of the response $c(n)$. C has a number of columns equal to the length of $h(n)$ with which the response is being convoluted. Assuming the sequence $h$ has length denoted by $N_h$ then the number of rows of C is equal to $(N_h+N_c-1)$. Then, using a deterministic least squares (LS) approach to compare against a desired response, (in a non-limiting example, defined as the Kronecker delta function $\delta(n\text{-}m)$), one can express the LS optimal inverse filter as outlined in equation 2:

$$h(n) = (C^T C)^{-1} C^T a_m$$

[equation 2]

where $a_m(n)$ is a column vector of zeroes with 1 in the $m$ th position to create the modeling delay. The compensation filter $h(n)$ can then be computed from equation 2 using a range of computational methods.

In aspects, the parametrically configurable transfer function(s) may be iteratively determined by subsequently running test audio signals on the CED with the updated transfer function(s) and monitoring the modified acoustic signature of the CED with the audio sensors. A least squares optimization algorithm may be implemented to iteratively update the transfer function(s) between test regiments until an optimal modified acoustic signature of the CED is obtained. Other, non-limiting examples of optimization techniques include non-linear least squares, L2 norm, averaged one-dependence estimators (AODE), Kalman filters, Markov models, back propagation artificial neural networks, Baysian networks, basis functions, support vector machines, k-nearest neighbors algorithms, case-based reasoning, decision trees, Gaussian process regression, information fuzzy networks, regression analysis, self-organizing maps, logistic regression, fractional derivative based optimization, time series models such as autoregression models, moving average models, autoregressive integrated moving average models, classification and regression trees, multivariate adaptive regression splines, and the like.

Due to the spatial nature of the acoustic signature of a CED, the optimization process may be configured so as to minimize error between an ideal system response and the actual system response as measured at several locations within the sound field of the CED. The multi-channel data obtained via the audio sensors may be analyzed using sensor fusion approaches. In many practical cases, the usage case of the CED may be reasonably well defined (e.g. the location of the user with respect to the device, the placement of the device in an environment, etc.) and thus a suitable spatial weighting scheme can be devised in order to prioritize the audio response of the CED in certain regions of the sound field that correspond to the desired usage case. In one, non-limiting example, the acoustic response within the forward facing visual range of a laptop screen may be favored over the acoustic response as measured behind the laptop screen during such tests. In this way, a more optimal multi-rate filter system may be formulated to suit a particular usage case for the CED.

In aspects, a method for optimizing a multi-rate filter system in accordance with the present disclosure may include optimizing the HDL implementation for reduced power, reduced footprint, or for integration into a particular semiconductor manufacturing process (e.g. 13nm - 0.5µm CMOS, CMOS-Opto, HV-CMOS, SiGe BiCMOS, etc.). This may be advantageous for providing an enhanced audio experience for a consumer electronic device without significantly impacting power consumption or adding significant hardware or cost to an already constrained device.

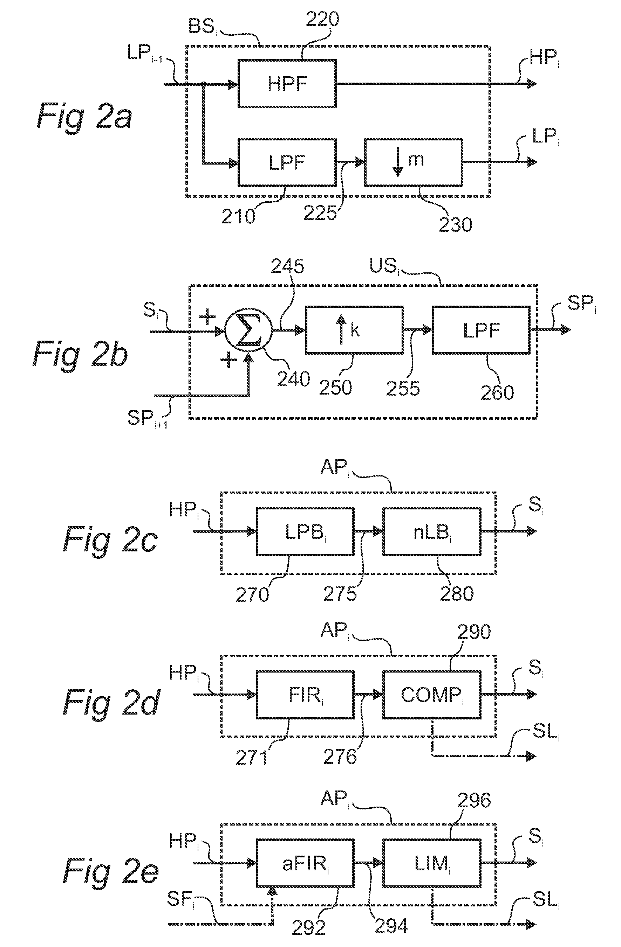

Fig. 2a shows a bandselector $BS_i$ in accordance with the present disclosure. The bandselector $BS_i$ includes a bandselector input $LP_{i-1}$, a highpass bandselector output $HP_i$, and a lowpass bandselector output $LP_i$. The bandselector $BS_i$ includes a high pass filter 220 connected between the bandselector input $LP_{i-1}$ and the highpass bandselector output $HP_i$. The bandselector $BS_i$ also includes a low pass filter 210 connected to the bandselector input $LP_{i-1}$ and an intermediate filtered signal 225. The bandselector $BS_i$ also includes a downsampler 230 connected to the intermediate filtered signal 225 and the lowpass bandselector output $LP_i$. The low pass and high pass filters may be selected as known to one skilled in the art. The architecture herein may be advantageous in providing a simple structure to provide the low pass and high pass filters as a complimentary digital filter pair.

In aspects, one or more of the low pass and/or high pass filters may be configured with linear phase characteristics (e.g. as linear phase FIR filters, etc.). In aspects, one or more of the low pass and/or high pass filters may be configured with near linear phase characteristics (i.e. with phase characteristics that deviate from a linear phase characteristic by less than a predetermined limit). Such configurations may be advantageous to manage and/or reduce the overall phase distortion introduced to the signal path by the multi-rate filter system during use (e.g. as may be introduced during reconstruction of the individual bands during formation of the output signal). Near linear phase filter characteristics may be advantageous for managing the relationship between the overall phase distortion and the delay associated with the multi-rate filter system.

Fig. 2b shows a bandcombiner $US_i$ in accordance with the present disclosure. The bandcombiner $US_i$ includes two bandcombiner inputs $S_i$, $SP_{i+1}$ and a bandcombiner output $SP_i$. The bandcombiner $US_i$ includes a summer connected to the bandcombiner inputs $S_i$, $SP_{i+1}$ and an intermediate combined signal 245. The bandcombiner $US_i$ further includes an upsampler 250 connected to the intermediate combined signal 245 to produce an upsampled intermediate signal 255. The bandcombiner $US_i$ includes a low pass filter 260 connected to the upsampled intermediate signal 255 and the bandcombiner output $SP_i$ so as to ensure the output thereof is not aliased and/or imaged.

In aspects, the upsampler 250 may be configured with one or more interpolation filters so as to reduce imaging associated with the upsampled intermediate signal 255.

In aspects, the bandcombiner $US_i$ may include one or more filter elements (i.e. the low pass filter 260, included in the upsampler 250, etc.) configured so as to manage, reduce, and/or minimize the delay introduced into the signal during use. Such filter elements may be configured as linear phase filters, near linear phase filters (e.g. a filter prescribed wherein the filter phase variation is within a predetermined tolerance of a linear phase variation), or the like. Such filters may be optimized during an optimization method in accordance with the present disclosure.

Fig. 2c shows an example of a signal processing block $AP_i$ in accordance with the present disclosure. The signal processing block $AP_i$ is connected to an associated highpass bandselector output $HP_i$ and a first bandcombiner input $S_i$. The signal processing block $AP_i$ includes a linear filter component 270 and a nonlinear filter component 280 both in accordance with the present disclosure. The linear filter component 270 and the nonlinear filter component 280 are shown connected in series by a linear filtered signal 255. The nonlinear filter component 280 is configured to produce a nonlinear filtered signal (e.g. in this case the first bandcombiner input $S_i$). Other interconnections of the filter components may be used in practice (serial connections, parallel connections, functionally equivalent merging of components, etc.). In aspects, one or more of the filters 270, 280 may include a delay function and/or a phase compensation function.

Fig. 2d shows an alternative example of a signal processing block $AP_i$ in accordance with the present disclosure. The signal processing block $AP_i$ is connected to an associated highpass bandselector output $HP_i$ and a first bandcombiner input $S_i$. The signal processing block $AP_i$ includes a finite impulse response (FIR) filter 271 connected in series with a compressor 290 both in accordance with the present disclosure. The finite impulse response (FIR) filter 271 is configured to output a linear filtered signal 276. The compressor 290 is configured to accept the linear filtered signal 276 and output a nonlinear filtered signal (e.g. in this case the first bandcombiner input $S_i$). One or more of the filters 271, 290 may include a delay function and/or a phase compensation function.

In aspects, the compressor 290 may include an observer. The observer may be configured to monitor at least one signal within the signal processing block $AP_i$ (e.g. the linear filtered signal 276, the first bandcombiner input Si, an intermediate signal, a representation of such signals, etc.). In aspects, the observer may be configured to calculate a strength signal.

In aspects, the strength signal may be evaluated simply as being equal to a band-passed input signal. Some other non-limiting examples for calculating a strength signal from an associated input signal (or filtered version thereof) include, a power signal, instantaneous power signal, averaged power signal, frequency band averaged signal, peak signal, an envelope, a filtered envelope, a Kalman-filtered power estimation technique, noise power spectral density, loudspeaker excursion estimators, an autocorrelation parameter, combinations thereof, or the like.

In aspects, the compressor (e.g. or equivalently a nonlinear filter component) may be configured to respond to the observer output (e.g. an observer signal $SL_i$). The observer may be configured to output an observer signal $SL_i$ for use by another component and/or block in the multi-rate filter system.

Fig. 2e shows an alternative example of a signal processing block $AP_i$ in accordance with the present disclosure. The signal processing block $AP_i$ is connected to an associated highpass bandselector output $HP_i$ and a first bandcombiner input $S_i$. The signal processing block $AP_i$ includes an adaptive finite impulse response (aFIR) filter 292 connected to a feedback signal channel $SF_i$ and connected in series with a compressor 296 (in this case a limiter) both in accordance with the present disclosure. The adaptive finite impulse response (FIR) filter 292 is configured to output a linear filtered signal 294. The limiter 296 is configured to accept the linear filtered signal 294 and output a nonlinear filtered signal (e.g. in this case the first bandcombiner input $S_i$).

In general the adaptation process associated with the adaptive finite impulse response (aFIR) filter 292 may be configured so as to be sufficiently slow to maintain an essentially linear behavior from the aFIR filter 292 over the signal bandwidth of interest (e.g. the audio frequency band).

In aspects, the limiter 296 may include an observer in accordance with the present disclosure. The observer may be configured to monitor at least one signal within the signal processing block APi (e.g. the linear filtered signal 294, the first bandcombiner input Si, an intermediate signal, a representation of such signals, etc.). The observer may be configured to calculate a strength signal in accordance with the present disclosure.

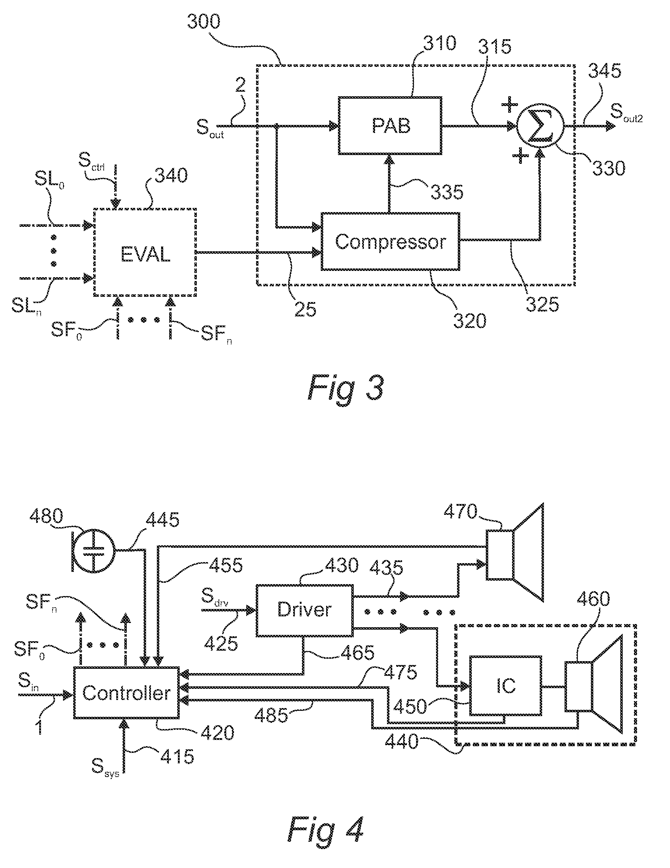

Fig. 3 shows a nonlinear functional block 300 for implementing an audio enhancement algorithm in combination with a multi-rate filter system in accordance with the present disclosure. In the non-limiting example shown, the nonlinear functional block 300 shows an illustrative example of a bass enhancement system 300 in accordance with the present disclosure. The bass enhancement system 200 may be configured to accept an input signal, $S_{out}$ 2 from the multi-rate filter system and a control signal 25 from an evaluation block 340, to produce an enhanced output signal, $S_{out2}$ 345. The evaluation block 340 may be configured to accept an external control signal $S_{ctrl}$, one or more feedback signals $SF_0$ to $SF_n$, and one or more observer signals $SL_0$ to $SL_n$. The evaluation block 340 may combine signals operably generated by many multi-rate filter blocks 10 to form a collective strength signal, power level, etc. to optionally direct the bass enhancement system 300.

In aspects, the bass enhancement system 300 may include a psychoacoustic bass enhancement block (PAB) 310 and a compressor 320. The compressor 320 may be configured to accept the input signal 2 or a related signal thereof (e.g. filtered, resampled, clipped, input signal 2, etc.), and the control signal 25, and to produce a first enhanced signal 325 and an internal control signal 335. The PAB 330 may be configured to accept the input signal 2 or a related signal therefrom (e.g. filtered, resampled, clipped, input signal 2, etc.) and the internal control signal 335, and to produce a second enhanced signal 315. In aspects, the first enhanced signal 325 and the second enhanced signal 315 may be combined (e.g. added, mixed, etc.) in a combination block 340 to produce the enhanced output signal, $S_{out2}$ 345.

The system 300, the PAB 330 and/or the compressor 320 may include one more filters (e.g band pass filters, low pass filters, high pass filters, adaptable filters, polyphase FIR filters, FIR filters, lattice wave filters, etc.) for isolating one or more frequency bands (e.g. band-1, band-2, band-3, band-m, band-n signals, etc.) from the input signal 2 for further analysis and/or enhancement. In aspects, the compressor 320 may include a filter for isolating a portion of the input signal content residing roughly within the bass audio range (e.g. 10-80Hz, 30 - 60Hz, 35-50Hz, 100-300Hz, 120-250Hz, etc.). The compressor 320 may be configured to adjust the bandwidth limits of the filter in real-time (e.g. as directed by the external control signal $S_{ctrl}$). Alternatively, additionally, or in combination the multi-rate filter system may be tapped at one or more bandcombiner outputs $SP_i$ in order to retrieve one or more band limited signals for use in the nonlinear functional block 300 (e.g. the bass enhancement system).

Fig. 4 shows an illustrative example of a feedback system including a controller 420 and some illustrative feedback mechanisms in accordance with the present disclosure. The controller 420 may be configured to generate one or more feedback signals $SF_0$ to $SF_n$ (equivalently considered external control signals). The control signals 495 maybe used by various blocks in multi-rate filter system to control gain adjustments, adapt filter parameters, and the like. The controller 420 may be connected to the input channel 1 so as to accept the input signal $S_{in}$ to contribute to the generation of the feedback signals $SF_0$ to $SF_n$. In aspects, the controller 420 may be configured to accept the input signal 1 and to generate one or more feedback signals $SF_0$ to $SF_n$ with an entirely feed forward signal path. The controller 420 may be configured to accept a system control signal $S_{sys}$ 415 so as to adjust one or more control signals 495.

In aspects, the system control signal 415 may be a power management signal, a volume scale, a power setting (e.g. ultra-low power, low power, full power, etc.), a signal related to trade-off between audio quality and power, a user input signal, or the like.

When implemented into an audio processing system, the audio processing system may include a driver 430. The driver 430 may be driven by an audio processing output signal 425, at least partially dependent on the output signal $S_{out}$ and/or the enhanced signal 355. The driver 430 may generate one or more output signals 435 for driving one or more loudspeakers 460, 470, loudspeaker driver modules 440, and/or integrated circuits 450 included therein. The controller 420 may be configured to accept one or more sensor signals 445, 455, 465, 475, 485 from one or more audio components within a complete audio signal processing system. Some non-limiting examples include current, voltage, and/or temperature sensor signal 465 from the driver 430, a current, voltage, displacement, temperature, and/or acceleration sensor signal 455, 485 from one or more of the loudspeakers 460, 470, and a current, voltage, impedance, temperature, limiter, and/or envelop sensor signal 450 from one or more integrated circuits 450 included in the audio processing system.

In aspects, the controller 420 may be configured to accept an audio sensor signal 445 as operably produced by one or more microphones 480 included in the audio processing system. The controller 420 may be configure to accept a sensor signal (not explicitly shown) from one or more accelerometers, gyroscopes, GPS sensors, temperature sensors, humidity sensors, battery life sensors, current sensors, magnetic field sensors, or the like.

In aspects, a range of feedback algorithms may be implemented in the controller 420 to relate the sensor signals 445, 455, 465, 475, 485 to the feedback signals $SF_0$ to $SF_n$. Some non-limiting examples of feedback algorithms include speaker/drive temperature overload feedback, negative feedback based on one or more aspects of the audio sensor signal 445 (e.g. an amplitude based feedback, a distortion based feedback, etc.), a distortion limiting algorithm (e.g. via measurement of the audio sensor signal 445), combinations thereof, and the like.

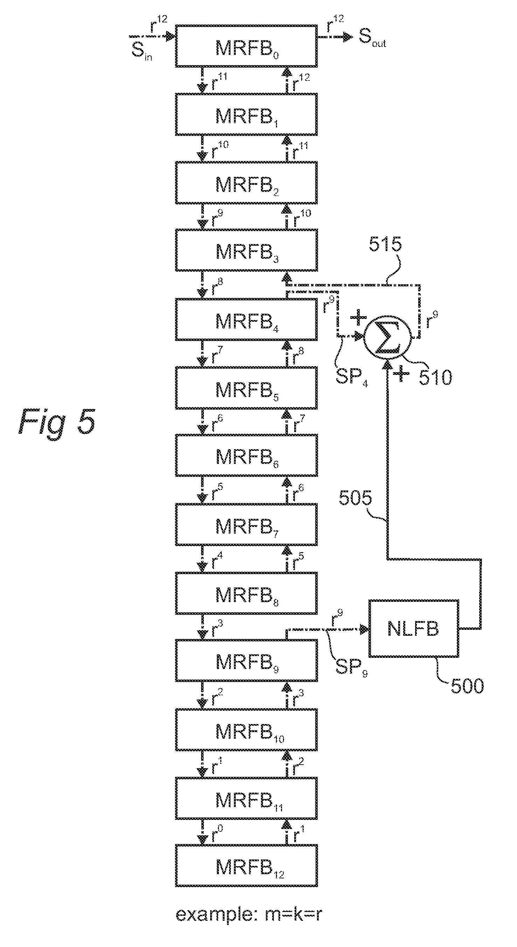

Fig. 5 shows a non-limiting example of a multi-rate filter system including a nonlinear functional block in accordance with the present disclosure. The multi-rate filter system includes a plurality of multi-rate filter blocks $MRFB_0$ to $MRFB_{12}$ each in accordance with the present disclosure. The multi-rate filter block $MRFB_0$ is connected to an input channel 1, configured so as to accept an input signal $S_{in}$, and is connected to an output channel 2, configured so as to output a filtered signal $S_{out}$. The downsampler and upsampler in each multi-rate filter block $MRFB_i$ are configured with sampling ratios equal to "r". Such a limitation is only for illustration purposes. The sampling ratios may be configured to any values and need not be equal to each other.

In aspects, the maximum frequency associated with each signal within the multi-rate filter system is indicated as a power of r (e.g. $r^n$). Thus the bands associated with this multi-rate filter are logarithmically spaced across the signal spectrum. Such limitation is shown only for illustrative purposes. The sampling ratios may be configured to any unique values and need not be equal to each other.

In aspects, the multi-rate filter system may include a nonlinear functional block 500 in accordance with the present disclosure. The nonlinear functional block 500 is connected to the bandcombiner output $SP_9$ of the multi-rate filter block $MRFB_9$. In the example shown, the bandcombiner output is oversampled (i.e in this case to a value corresponding to the upper band limit of $r^9$). Thus there is sufficient headroom in $SP_9$ to accommodate at least a portion of the distortion introduced by the nonlinear functional block 500. The nonlinear functional block 500 is connected to a summer 510. The summer 510 may be connected to the bandcombiner output $SP_4$ of the multi-rate filter block $MRFB_4$. In this non-limiting example, the sample rates of the summer 510 inputs are equivalent. The summer output 515 is connected to the prior multi-rate filter block $MRFB_3$ so as to add the nonlinear functional block 500 enhanced signal back into the multi-rate filter block cascade.

In aspects, the nonlinear functional block 500 may be a bass enhancement block 300 in accordance with the present disclosure. The nonlinear functional block 500 may also be equivalent to any nonlinear filter component in accordance with the present disclosure.

The structure shown may be advantageous for effectively coupling highly nonlinear functions into the cascade structure of the multi-rate filter system.

In aspects, the multi-rate filter block cascade may be tapped at any bandcombiner output $SP_i$. Such taps may be used to construct wider band signals from the individual band signal of the multi-rate filter cascade.

In aspects, the sample rates of at least one downsampler and/or upsampler in the multi-rate filter system may be adaptively configurable. At least one downsampler and/or upsampler sample rate may be configured so as to coincide with an acoustic feature (e.g. an acoustic resonance, a bass band transition, a jitter, etc.) of an associated consumer electronics device into which the multi-rate filter system is included.

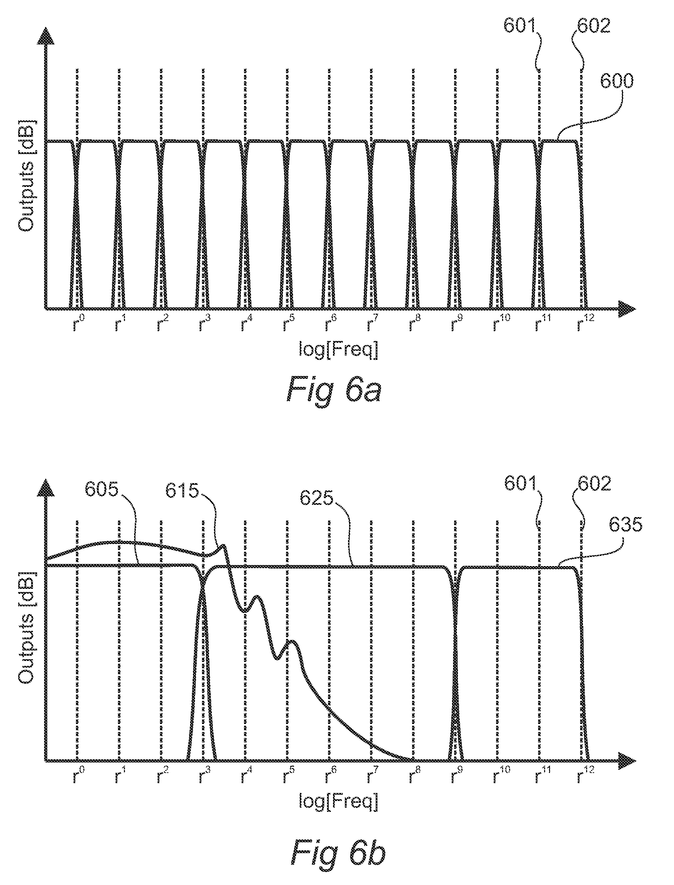

Fig. 6a-b show examples of the frequency spectrum associated with the example multi-rate filter system shown in Fig. 5. Fig. 6a shows a log-log relationship between frequency and frequency content of a signal 600 associated with each multi-rate filter block 10 of this specific example. The signal 600 is bound by an upper limit frequency 602 and a lower limit frequency 601. As shown, the bands are logarithmically spaced in frequency. Such a limitation is only shown for illustration purposes and in aspects, the bands may be arbitrarily assigned. The sampling ratios may be configured to any values and need not be equal to each other. In aspects, the bands may be linearly spaced across the signal spectrum, nonlinearly spaced, logarithmically spaced, randomly spaced, etc.

Fig. 6b shows further examples of signal content associated with the example of Fig. 5. Fig. 6b shows a bass band portion 605 of the overall signal, as tapped at $SP_9$ in the example. The bass band portion 605 is passed to the nonlinear functional block 500 to produce a nonlinear filtered portion 615. In the non-limiting example shown, the nonlinear filtered portion 615 contains significant distortion, thus introducing signal content with a considerably higher frequency than could be sampled from the $r^3$ band. Thus, by upsampling the bandcombiner output $SP_9$ to $r_9$, the additional frequency content can be accommodated without aliasing. The signal portion between SP6 and SP4 is shown as a midband portion 625 and is added to with the nonlinear filtered portion 615 in the summer and returned to the cascade to be integrated and upsampled with content in the upper band portion 635 of the signal.

In aspects, the multi-rate filter system may be embedded in an application specific integrated circuit (ASIC) or be provided as a hardware descriptive language block (e.g. VHDL, Verilog, etc.) for integration into a system on chip (SoC), an application specific integrated circuit (ASIC), a field programmable gate array (FPGA), or a digital signal processor (DSP) integrated circuit.

In aspects, a multi-rate filter system in accordance with the present disclosure may be configured to substantially match a predetermined single rate wide band filter. The wide band filter may be configured to compensate for one or more rendering characteristics of an audio rendering device (e.g. a consumer electronics device, a media rendering network, etc.). In one non-limiting example, the multi-rate filter system may be configured with a series of bands to collectively span the wide band spectrum associated with the wide band filter. The multi-rate filter system may include N bands, the bands configured as follows: N-1 bands spaced so as to fill a high frequency portion of the wide band filter spectrum (i.e. configured so as to span from the upper limit of the spectrum, $F_{max}$, down to a low to mid band frequency $F_m$), and an additional low band spanning from a substantially lower limit of the spectrum $F_{min}$, up to the low to mid band frequency $F_m$. Each of the bands (i.e. each of the N-1 bands, the low frequency band, etc.) may include a signal processing block $AP_i$ connected to a bandselector $BS_i$ in accordance with the present disclosure. The N-1 bands may be spaced linearly, logarithmically, with individually configured bandwidth, etc. in accordance with the present disclosure. In aspects, the low band may be configured so as to cover a bass band of the spectrum (e.g. perhaps correlated with the bass band of the associated device, covering relevant spectrum less than 1000 Hz, less than 500 Hz, less than 300 Hz, less than 150Hz, less than 120Hz, less than 80Hz, etc.).

In aspects, the N-1 bands may be logarithmically spaced in accordance with the present disclosure (i.e. each band covering 1:m spectrum wherein m is a real number, 1:2, 1:1.5, half octave bands, quarter octave bands, etc.).

One or more of the low pass filters in each band may be configured to reduce cross talk, aliasing, imaging, etc. associated with the adjacent band structures, downsampling, and upsampling aspects of the multi-rate filter system. In one non-limiting example, one or more of the low pass filters may be formed from linear phase FIR filters. One or more of the low pass filters may be configured with cutoff characteristics suitably placed to reduce aliasing and/or imaging of the signals to be processed by the associated bandselector $BS_i$, bandcombiner $US_i$, and/or signal processing block $AP_i$. In aspects, related to the use of linear phase filters, bands associated with shorter paths may include a delay element so as to maintain an equal delay between all band signals in the multi-rate filter system.

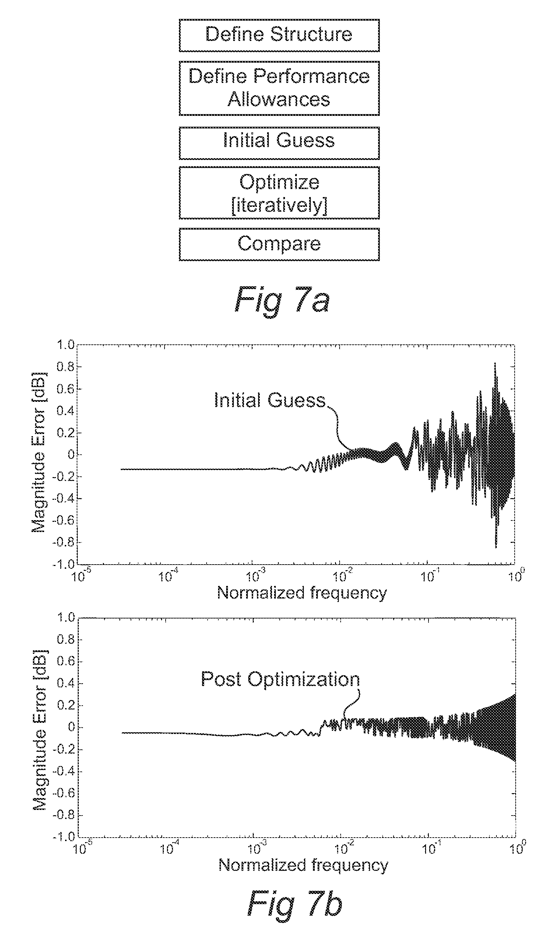

Fig. 7a-b show a method for optimizing a multi-rate filter to match a wide band target filter in accordance with the present disclosure and a resulting filter frequency response. Fig. 7a shows a method for optimizing a multi-rate filter system to match a wide band target filter in accordance with the present disclosure. The method includes defining the structure of the multi-rate filter system, defining the performance allowances (i.e. phase delay, phase distortion, and/or magnitude mismatch), providing an initial guess to match the target filter, optimizing the multi-rate filter system to match the target filter, comparing the optimized filter and the target in accordance with the performance allowances, and optionally iterating any of the above steps in order to satisfy the performance allowances.

In aspects, the step of optimizing may include optimizing the multi-rate filter system on the whole, in parts, or by fixing one or more portions of the system while optimizing one or more alternative aspects. The optimization procedure may be completed using one or more known techniques (e.g. nonlinear programming solvers, minimax constraint problem solvers, etc.). Other, non-limiting examples of optimization techniques include non-linear least squares, L2 norm, averaged one-dependence estimators (AODE), Kalman filters, Markov models, back propagation artificial neural networks, Baysian networks, basis functions, support vector machines, k-nearest neighbors algorithms, case-based reasoning, decision trees, Gaussian process regression, information fuzzy networks, regression analysis, self-organizing maps, logistic regression, fractional derivative based optimization, time series models such as autoregression models, moving average models, autoregressive integrated moving average models, classification and regression trees, multivariate adaptive regression splines, and the like.

In aspects, one or more of the filters in the multi-rate filter system may be optimized separately from each other. The filters in the bandselector $BS_i$ and the bandcombiner $US_i$ may be designed (and optionally optimized) so as to define the band structures of the multi-rate filter to conform with the overall performance allowances of the filter. The bandselector $BS_i$ and the bandcombiner $US_i$ filters may be matched so as to provide the same values and/or reduce complexity of the filter system (i.e. perhaps so as to provide matching filter parameters, reduce memory requirements, etc.). The resulting bandselector $BS_i$ and the bandcombiner $US_i$ filters may then be held constant while the processing filters included in each of the signal processing blocks $AP_i$ are optimized in a secondary optimization procedure.

Additionally, alternatively, or in combination the filters in the multi-rate filter system may be collectively optimized with reference to the performance allowances. Such an approach may be advantageous for flexibly trading off between the performance allowances (i.e. may allow for more control over delay, phase distortion, and/or magnitude variation).

For purposes of demonstration, in one non-limiting example, the predetermined wide band filter may be a FIR filter with 2048 taps (e.g. a minimum phase FIR filter, linear phase FIR filter, etc.). The basic computational requirement for the wide band filter is 2048 computations per sample (i.e. 90MIPS at 44.1kHz). An associated multi-rate filter may be provided with N bands (e.g. N = 2, 3, 4, 5, 6, etc.) in accordance with the present disclosure. In one non-limiting example, the multi-rate filter may include logarithmically spaced bands (i.e. in a multi-rate filter with N = 3, the bands may be approximately 22kHz:44kHz, 11kHz:22kHz, $F_{min}$:11kHz).

The multi-rate filter may be structured in accordance with the method described herein, and the performance allowances may be defined a priori. In one non-limiting example, the allowable delay is preferably less than or equal to 10ms, the allowable phase distortion is zero (i.e. a linear phase configuration with associated delay elements in each band), and the allowable magnitude variation is set at less than or equal to 0.25dB. For purposes of discussion, in this example, the delay allowance is relaxed while the linear phase aspect is enforced. Filters in the bandselector $BS_i$ and the bandcombiner $US_i$ are selected to have an order of 40. Initial guesses for the bandselector $BS_i$ and the bandcombiner $US_i$ filters were calculated using a Parks-McClellan algorithm and then optimized subject to weighted constraints relating to pass band flatness, stopband ripple, etc. of each of the filters.

Continuing with the example, processing filters associated with each signal processing block $AP_i$ are of order 64, except for the lowest band filter, which is arbitrarily provided with order 1024, 512, 256, 128, or 64 for N varying between N=2 and N = 6. Initial guesses for the processing filters were made using a Parks-McClellan algorithm. The resulting optimized filters were then generated using an optimization technique in accordance with the present disclosure subject to constraints related to minimization of amplitude error under the constraints of minimum phase filter properties. Such a configuration may be advantageous for simplifying the overall optimization process.

In accordance with this example, the associated memory requirements, and computations requirements as a function of N are shown in Table 1:

Table 1:

| Order <N> | Memory | Requirement <words> | Computational Requirements <MIPS> |
|---|---|---|---|
| wideband | 4096 | | 90.3 |
| 2 | 2320 | | 29.0 |
| 3 | 1606 | | 15.3 |

(continued)

| Order <N> | Memory Requirement <words> | Computational Requirements <MIPS> |
|---|---|---|
| 4 | 1564 | 12,68 |
| 5 | 2098 | 12.43 |
| 6 | 3400 | 12.56 |

As can be seen from Table 1, the computational requirements for the multi-band filter system are considerably lower than those of the wideband filter for all N values studied. The memory requirements are also improved for a range of N (in this case for N values of 2 through 6).

Fig. 7b shows the error magnitude between the target wideband filter, the initial guess and for the post optimized multi-rate filter for the procedure described herein (shown in separate graphs). As can be seen in Fig. 7b, the magnitude error between the multi-rate filter and the target filter has been reduced by roughly a factor of 4 during the optimization procedure versus the initial guess.

In aspects, a multi-rate filter system in accordance with the present disclosure may be soft-coded into a processor, coded in VHDL, Verilog or other hardware descriptive language, flash, EEPROM, memory location, or the like. Such a configuration may be used to implement the multi-rate filter system in software, as a routine on a DSP, an FPGA, A CPLD, a processor, and ASIC, etc.

It will be appreciated that additional advantages and modifications will readily occur to those skilled in the art. Therefore, the disclosures presented herein and broader aspects thereof are not limited to the specific details and representative embodiments shown and described herein. Accordingly, many modifications, equivalents, and improvements may be included without departing from the scope of the invention as defined by the appended claims.

**Claims**

1. A multi-rate filter system comprising:

    an input channel (1) configured to receive an input signal;
    an output channel (2) configured to output a filtered signal;
    a cascade of multi-rate filter blocks coupled between the input channel and the output channel, wherein at least one of the multi-rate filter blocks after a first multi-rate filter block in said cascade comprises:
    a bandselector ($BS_i$) comprising a bandselector input, a highpass bandselector output, a lowpass bandselector output connected to a subsequent multi-rate filter block, and a downsampler (230) connected between the bandselector input and the lowpass bandselector output;
    a signal processing block ($AP_i$) coupled to the highpass bandselector output, the signal processing block comprising a linear filter component (270); and
    a bandcombiner ($US_i$) connected to the signal processing block ($AP_i$), the bandcombiner comprising two bandcombiner inputs, a bandcombiner output, and an upsampler (250), the first bandcombiner input connected to the signal processing block, the second bandcombiner input connected to a subsequent multi-rate filter block, and the bandcombiner output connected to a prior multi-rate filter block, the upsampler (250) connected between the bandcombiner inputs and the bandcombiner output.

2. The multi-rate filter system in accordance with claim 1, wherein the linear filter component (270) is selected from a group comprising a finite impulse response (FIR) filter, an infinite impulse response (IIR) filter, a Kalman filter, a neural network, a fuzzy logic filter, and combinations thereof, and wherein the linear filter component comprises reconfigurable filter parameters.

3. The multi-rate filter system in accordance with any preceding claim, wherein at least one of the signal processing blocks comprises a nonlinear filter component (280) connected to the linear filter component, and wherein the nonlinear filter component is selected from a group comprising a compressor, a polynomial, a limiter, and combinations thereof.

4. The multi-rate filter system in accordance with claim 3, wherein at least one multi-rate filter block comprises an observer including a power monitor and configured to output an observer signal, the observer connected to the signal processing block between the highpass bandselector output and the first bandcombiner input, and wherein the nonlinear filter component is configured to respond to the observer signal.

5. The multi-rate filter system in accordance with any preceding claim, comprising a nonlinear functional block (NLFB) (500) comprising an NLFB input and an NLFB output, a first multi-rate filter block comprising a bandcombiner output, and a second multi-rate filter block comprising a bandcombiner input, the NLFB input connected to the bandcombiner output of the first multi-rate filter block, and the NLFB output connected to the bandcombiner input of the second multi-rate filter block.

6. The multi-rate filter system in accordance with any preceding claim, wherein the downsampler (230) is an m:1 downsampler, and where m is a sample rate and the upsampler (250) is a 1 :k upsampler, and where k is a sample rate, and wherein m is equal to k., or m and/or k are less than or equal to 2, less than or equal to 1.5, less than or equal to 1.33, or less than or equal to 1.25.

7. The multi-rate filter system in accordance with any preceding claim, wherein the bandselector (BS$_i$) comprises a low pass filter (210) connected between the bandselector input and the bandselector lowpass output, and a high pass filter (220) connected between the bandselector input and the bandselector highpass output, wherein the bandselector comprises a complimentary filter pair formed by the low pass filter and high pass filter, and wherein the low pass filter is selected from a group consisting of a linear phase FIR filter, a near linear phase FIR filter, a lattice wave filter, and combinations thereof.

8. The multi-rate filter system in accordance with any preceding claim, wherein the bandcombiner (US$_i$) comprises a summer (240) connected to the bandcombiner inputs and the upsampler (250) and a low pass filter (260) connected between the upsampler and the bandcombiner output.

9. The multi-rate filter system in accordance with any preceding claim in combination with claim 3, further comprising a control channel configured to receive a control signal, at least one multi-rate filter block connected to the control channel, and wherein the nonlinear filter component is configured to respond to the control signal.

10. Use of a multi-rate filter system in accordance with any preceding claim, in a consumer electronics device.

11. A method for filtering a signal, the method comprising:

processing an input signal with a plurality of cascaded multi-rate filter blocks, the processing of at least one multi-rate filter block after a first multi-rate filter block comprising:

selecting a high frequency band and a low frequency band of a received signal;
downsampling the low frequency band of the received signal to produce a downsampled signal;
providing the downsampled signal to a subsequent multi-rate filter block;
processing the high frequency band of the received signal with a linear filter component to form a filtered signal;
combining the filtered signal with a further filtered signal from the subsequent multi-rate filter block to form a filtered output signal; and
upsampling the filtered output signal to form an increased rate signal.

12. The method in accordance with claim 11, further comprising processing at least one increased rate signal with a nonlinear functional block (NLFB) to form a nonlinear processed signal.

13. The method in accordance with claim 12, further comprising:

providing the nonlinear processed signal to a prior multi-rate filter block; and
providing the increased rate signal to a prior multi-rate filter block.

14. A method for matching a multi-rate filter system in accordance with any one of claims 1 - 9 to a predetermined wideband filter, the method comprising:

assigning the number of multi-rate filter blocks in the multi-rate filter system;
calculating an initial guess for one or more of the multi-rate filter blocks;
optimizing the multi-rate filter blocks towards the wideband filter to form one or more updated multi-rate filter blocks; and
constructing a matched multi-rate filter system from the updated multi-rate filter blocks.

15. The method in accordance with claim 14, wherein the step of calculating is performed using a Parks-McClellan algorithm.

16. The method in accordance with claim 14 or 15, wherein the step of optimizing is performed on one or more bandselectors and one or more bandcombiners included in the multi-rate filter system, and separately on one or more of the signal processing blocks included in the multi-rate filter system.

17. The method in accordance with any one of claims 14 - 16, further comprising adding a nonlinear function block to one or more of the multi-rate filter blocks.

18. The method in accordance with claim 17, further comprising configuring the nonlinear function block to match a psychoacoustic function.


**Patentansprüche**

1. Ein Multi-Rate-Filtersystem, welches umfasst:

einen Eingangskanal (1), konfiguriert für den Empfang eines Eingangssignals;
einen Ausgangskanal (2), konfiguriert für die Ausgabe eines gefilterten Signals;
eine Kaskade von Multi-Rate-Filterblöcken, gekoppelt zwischen dem Eingangskanal und dem Ausgangskanal, worin mindestens einer der Multi-Rate-Filterblöcke nach einem ersten Multi-Rate-Filterblock in besagter Kaskade folgende Elemente umfasst:

einen Bereichsschalter ($BS_i$), der folgende Elemente umfasst: einen Bereichsschalter-Eingang, einen Hochpass-Bereichsschalter-Ausgang, einen Tiefpass-Bereichsschalter-Ausgang, verbunden mit einem nachfolgenden Multi-Rate-Filterblock, einen Downsampler (230), verbunden zwischen dem Bereichsschalter-Eingang und dem Tiefpass-Bereichsschalter-Ausgang;
einen Signalverarbeitungsblock ($AP_i$), gekoppelt an den Hochpass-Bereichsschalter-Ausgang, wobei der Signalverarbeitungsblock eine lineare Filterkomponente (270) umfasst; und
einen Band-Combiner ($US_i$), verbunden mit dem Signalverarbeitungsblock ($AP_i$), wobei der Band-Combiner zwei Band-Combiner-Eingänge, einen Band-Combiner-Ausgang und einen Upsampler (250) umfasst; der erste Band-Combiner-Eingang ist mit dem Signalverarbeitungsblock verbunden, der zweite Band-Combiner-Eingang mit einem nachfolgenden Multi-Rate-Filterblock verbunden, und der Band-Combiner-Ausgang mit einem vorherigen Multi-Rate-Filterblock verbunden, der Upsampler (250) ist zwischen den Band-Combiner-Eingängen und dem Band-Combiner-Ausgang verbunden.

2. Das Multi-Rate-Filtersystem gemäß Anspruch 1, worin die lineare Filterkomponente (270) aus einer Gruppe ausgewählt wird, die einen Filter mit endlicher Impulsantwort (FIR-Filter), einen Filter mit unendlicher Impulsantwort (IIR-Filter), einen Kalmanfilter, ein neuronales Netz, einen Fuzzylogik-Filter und Kombinationen davon umfasst, und worin die lineare Filterkomponente umkonfigurierbare Filterparameter umfasst.

3. Das Multi-Rate-Filtersystem gemäß einem der vorangehenden Ansprüche, worin mindestens einer der Signalverarbeitungsblöcke eine nichtlineare Filterkomponente (280) umfasst, die mit der linearen Filterkomponente verbunden ist, wobei die nichtlineare Filterkomponente aus einer Gruppe ausgewählt wird, die einen Kompressor, ein Polynom, einen Begrenzer und Kombinationen davon umfasst.

4. Das Multi-Rate-Filtersystem gemäß Anspruch 3, worin mindestens ein Multi-Rate-Filterblock einen Beobachter umfasst, der eine Leistungsüberwachung enthält und für die Ausgabe eines Beobachtersignals konfiguriert ist, wobei der Beobachter mit dem Signalverarbeitungsblock zwischen dem Hochpass-Bereichsschalter-Ausgang und dem ersten Band-Combiner-Eingang verbunden ist, und worin die nichtlineare Filterkomponente für das Ansprechen auf das Beobachtersignal konfiguriert ist.

5. Das Multi-Rate-Filtersystem gemäß einem der vorangehenden Ansprüche, welches folgende Elemente umfasst: einen nichtlinearen Funktionsblock (NLFB) (500), der einen NLFB-Eingang und einen NLFB-Ausgang umfasst, einen ersten Multi-Rate-Filterblock, der einen Band-Combiner-Ausgang umfasst, und einen zweiten Multi-Rate-Filterblock, welcher einen Band-Combiner-Eingang, den mit dem Band-Combiner-Ausgang des ersten Multi-Rate-Filterblocks verbundenen NLFB-Eingang und den mit dem Band-Combiner-Eingang des zweiten Multi-Rate-Filterblocks verbundenen NLFB-Ausgang umfasst.

6. Das Multi-Rate-Filtersystem gemäß einem der vorangehenden Ansprüche, worin der Downsampler (230) ein m:1-Downsampler ist und wobei m eine Abtastrate ist, und worin der Upsampler (250) ein 1:k-Upsampler ist, wobei k eine Abtastrate ist, und worin m gleich k ist oder m und/oder k kleiner oder gleich 2, kleiner oder gleich 1,5, kleiner oder gleich 1,33 oder kleiner oder gleich 1,25 sind.

7. Das Multi-Rate-Filtersystem gemäß einem der vorangehenden Ansprüche, worin der Bereichsschalter (BS$^i$) einen Tiefpassfilter (210) umfasst, welcher zwischen dem Bereichsschalter-Eingang und dem Bereichsschalter-Tiefpass-Ausgang verbunden ist, und einen Hochpassfilter (220), der zwischen dem Bereichsschalter-Eingang und dem Bereichsschalter-Hochpass-Ausgang verbunden ist, worin der Bereichsschalter ein komplementäres Filterpaar umfasst, das von dem Tiefpassfilter und dem Hochpassfilter gebildet wird, und worin der Tiefpassfilter aus einer Gruppe ausgewählt ist, die aus einem linearen Phasen FIR-Filter, einem nahen linearen Phasen-FIR-Filter, einem Gitterwellenfilter und Kombinationen davon besteht.

8. Das Multi-Rate-Filtersystem gemäß einem der vorangehenden Ansprüche, worin der Band-Combiner (US$_i$) einen Summierer (240) umfasst, der mit den Band-Combiner-Eingängen und dem Upsampler (250) verbunden ist, und einen Tiefpassfilter (260), der zwischen dem Upsampler und dem Band-Combiner-Ausgang verbunden ist.

9. Das Multi-Rate-Filtersystem gemäß einem der vorangehenden Ansprüche in Kombination mit Anspruch 3, welches ferner folgende Elemente umfasst: einen Steuerkanal, der für den Empfang eines Steuersignals konfiguriert ist, mindestens einen Multi-Rate-Filterblock, der mit dem Steuerkanal verbunden ist, und worin die nichtlineare Filterkomponente für das Ansprechen auf das Steuersignal konfiguriert ist.

10. Die Verwendung eines Multi-Rate-Filtersystems gemäß einem der vorangehenden Ansprüche, in einer Verbraucherelektronikvorrichtung.

11. Eine Methode zum Filtern eines Signals, welche umfasst:

die Verarbeitung eines Eingangssignals mit mehreren kaskadierten Multi-Rate-Filterblöcken, die Verarbeitung von mindestens einem Multi-Rate-Filterblock nach einem ersten Multi-Rate-Filterblock, umfassend:

die Auswahl eines Hochfrequenzbereichs und eines Niederfrequenzbereichs eines empfangenen Signals;
das Heruntersampeln des Niederfrequenzbereichs des empfangenen Signals zur Erzeugung eines heruntergesampelten Signals;
die Bereitstellung des heruntergesampelten Signals für einen nachfolgenden Multi-Rate-Filterblock;
die Verarbeitung des Hochfrequenzbereichs des empfangenen Signals mit einer linearen Filterkomponente zur Bildung eines gefilterten Signals;
die Kombination des gefilterten Signals mit einem weiteren gefilterten Signal von dem nachfolgenden Multi-Rate-Filterblock zur Bildung eines gefilterten Ausgangssignals; und
das Heraufsampeln des gefilterten Ausgangssignals zur Bildung eines Signals mit erhöhter Rate.

12. Die Methode gemäß Anspruch 11, welche ferner die Verarbeitung von mindestens einem Signal mit erhöhter Rate mit einem nichtlinearen Funktionsblock (NLFB) zur Bildung eines nichtlinearen verarbeiteten Signals umfasst.

13. Die Methode gemäß Anspruch 12, welche ferner Folgendes umfasst:

die Bereitstellung des nichtlinearen verarbeiteten Signals für einen vorherigen Multi-Rate-Filterblock; und
die Bereitstellung des Signals mit erhöhter Rate für einen vorherigen Multi-Rate-Filterblock.

14. Eine Methode zur Abstimmung eines Multi-Rate-Filtersystems gemäß einem der Ansprüche 1-9 mit einem vorgegebenen Breitbandfilter, wobei diese Methode Folgendes umfasst:

die Zuweisung der Zahl von Multi-Rate-Filterblöcken im Multi-Rate-Filtersystem;

die Berechnung einer Anfangsschätzung für einen oder mehrere der Multi-Rate-Filterblöcke;
die Optimierung der Multi-Rate-Filterblöcke im Hinblick auf den Breitbandfilter, um einen oder mehrere überarbeitete Multi-Rate-Filterblöcke zu bilden; und
den Aufbau eines abgestimmten Multi-Rate-Filtersystems aus den überarbeiteten Multi-Rate-Filterblöcken.

15. Die Methode gemäß Anspruch 14, worin der Schritt der Berechnung unter Verwendung eines Parks-McClellan-Algorithmus durchgeführt wird.

16. Die Methode gemäß Anspruch 14 oder 15, worin der Schritt der Optimierung an einem oder mehreren Bereichsschaltern und einem oder mehreren Band-Combinern ausgeführt wird, die im Multi-Rate-Filtersystem enthalten sind, und separat an einem oder mehreren der Signalverarbeitungsblöcke, welche im Multi-Rate-Filtersystem enthalten sind.

17. Die Methode gemäß irgendeinem der Ansprüche 14-16, welche ferner die Hinzufügung eines nichtlinearen Funktionsblocks zu einem oder mehreren der Multi-Rate-Filterblöcke umfasst.

18. Die Methode gemäß Anspruch 17, welche ferner die Konfiguration des nichtlinearen Funktionsblocks zur Abstimmung mit einer psychoakustischen Funktion umfasst.

## Revendications

1. Un système de filtre multidébit comprenant :

   un canal d'entrée (1) configuré pour recevoir un signal d'entrée ;
   un canal de sortie (2) configuré pour émettre en sortie un signal filtré ;
   une cascade de blocs de filtres multidébits couplés entre le canal d'entrée et le canal de sortie, dans lequel au moins un des blocs de filtres multidébits après un premier bloc de filtres multidébits dans ladite cascade comprend :

   un sélecteur de bande (BSi), comprenant une entrée de sélecteur de bande, une sortie de sélecteur de bande passe-haut, une sortie de sélecteur de bande passe-bas connectée à un bloc de filtres multidébits ultérieur et un sous-échantillonneur (230) connecté entre l'entrée de sélecteur de bande et la sortie de sélecteur de bande passe-bas ;
   un bloc de traitement du signal (APi), couplé à la sortie de sélecteur de bande passe-haut, le bloc de traitement du signal comprenant un composant de filtre linéaire (270) ; et
   un combineur de bandes (USi) connecté au bloc de traitement du signal (APi), le combineur de bandes comprenant deux entrées de combineur de bandes, une sortie de combineur de bandes et un suréchantilloneur (250), la première entrée de combineur de bandes connectée au bloc de traitement du signal, la seconde entrée de combineur de bandes connectée à un bloc de filtres multidébits ultérieur et la sortie de combineur de bandes connectée à un bloc de filtres multidébits antérieur, le suréchantilloneur (250) connecté entre les entrées de combineur de bandes et la sortie de combineur de bandes.

2. Le système de filtre multidébit selon la revendication 1, dans lequel le composant de filtre linéaire (270) est sélectionné parmi un groupe comprenant un filtre à réponse impulsionnelle finie (FIR), un filtre à réponse impulsionnelle infinie (IIR), un filtre de Kalman, un réseau de neurones, un filtre à logique floue et les combinaisons de ceux-ci et dans lequel le composant de filtre linéaire comprend des paramètres de filtre reconfigurables.

3. Le système de filtre multidébit selon l'une quelconque des revendications précédentes, dans lequel au moins un des blocs de traitement du signal comprend un élément de filtre non linéaire (280) connecté au composant de filtre linéaire et dans lequel le composant de filtre non linéaire est sélectionné parmi groupe comprenant un compresseur, un polynôme, un limiteur et les combinaisons de ceux-ci.

4. Le système de filtre multidébit selon la revendication 3, dans lequel au moins un bloc de filtres multidébits comprend un observateur comprenant un moniteur de puissance et configuré pour émettre en sortie un signal d'observateur, l'observateur connecté au bloc de traitement du signal entre la sortie de sélecteur de bande passe-haut et la première entrée de combineur de bandes et dans lequel le composant de filtre non linéaire est configuré pour répondre au signal de l'observateur.

**5.** Le système de filtre multidébit selon l'une quelconque des revendications précédentes, comprenant un bloc fonctionnel non linéaire (NLFB) (500) comprenant une entrée NLFB et une sortie NLFB, un premier bloc de filtres multidébits comprenant une sortie de combineur de bandes et un second bloc de filtres multidébits comprenant une entrée de combineur de bandes, l'entrée NLFB connectée à la sortie de combineur de bandes du premier bloc de filtres multidébits et la sortie NLFB connectée à l'entrée de combineur de bandes du second bloc de filtres multidébits.

**6.** Le système de filtre multidébit selon l'une quelconque des revendications précédentes, dans lequel le sous-échantillonneur (230) est un sous-échantillonneur m:1 et où m est un taux d'échantillonnage et le suréchantilloneur (250) est un suréchantilloneur 1:k et dans lequel k est un taux d'échantillonnage et où m est égal à k ou m et/ou k est inférieur ou égal à 2, inférieur ou égal à 1,5, inférieur ou égal à 1,33, ou inférieur ou égal à 1,25.

**7.** Le système de filtre multidébit selon l'une quelconque des revendications précédentes, dans lequel le sélecteur de bande (BSi) comprend un filtre passe-bas (210) connecté entre l'entrée de sélecteur de bande et la sortie passe-bas du sélecteur de bande et un filtre passe-haut (220) connecté entre l'entrée de sélecteur de bande et la sortie passe-haut du sélecteur de bande, dans lequel le sélecteur de bande comprend une paire de filtres complémentaires formés par le filtre passe-bas et le filtre passe-haut et dans lequel le filtre passe-bas est sélectionné parmi un groupe comprenant un filtre FIR à phase linéaire, un filtre FIR à phase proche du linéaire, un filtre à onde de réseau et des combinaisons de ceux-ci.

**8.** Le système de filtre multidébit selon l'une quelconque des revendications précédentes, dans lequel le combineur de bandes (USi) comprend un sommateur (240) connecté aux entrées de combineur de bandes (250) et un filtre passe-bas (260) connecté entre le suréchantilloneur et la sortie de combineur de bandes.

**9.** Le système de filtre multidébit selon l'une quelconque des revendications précédentes en combinaison avec la revendication 3, comprenant en outre un canal de commande configuré pour recevoir un signal de commande, au moins un bloc de filtres multidébits connecté à la chaîne de commande et dans lequel le composant de filtre non linéaire est configuré pour répondre au signal de commande.

**10.** L'utilisation d'un système de filtre multidébit selon l'une quelconque des revendications précédentes, dans un appareil électronique grand public.

**11.** Un procédé destiné au filtrage d'un signal, le procédé comprenant :

le traitement d'un signal d'entrée avec une pluralité de blocs de filtres multidébits en cascade, le traitement d'au moins un bloc de filtres multidébits après un premier bloc de filtres multidébits comprenant :

la sélection d'une bande de fréquence haute et d'une bande de fréquence basse d'un signal reçu ;
le sous-échantillonnage de la bande de fréquence basse du signal reçu pour produire un signal sous-échantillonné ;
la fourniture du signal sous-échantillonné à un bloc de filtres multidébits ultérieur ;
le traitement de la bande de fréquence haute du signal reçu avec un composant de filtre linéaire pour former un signal filtré ;
la combinaison du signal filtré avec un autre signal filtré en provenance du bloc de filtres multidébits ultérieur pour former un signal de sortie filtré ; et
le suréchantillonnage du signal de sortie filtré pour former un signal de débit augmenté.

**12.** Le procédé selon la revendication 11, comprenant en outre le traitement d'au moins un signal de débit augmenté avec un bloc fonctionnel non linéaire (NLFB) pour former un signal traité non linéaire.

**13.** Le procédé selon la revendication 12 comprend en outre :

la fourniture du signal traité non linéaire à un bloc de filtres multidébits antérieur ; et la fourniture du signal de débit augmenté à un bloc de filtres multidébits antérieur.

**14.** Un procédé destiné à la mise en correspondance d'un système de filtre multidébit selon l'une quelconque des revendications 1 à 9 à un filtre à large bande prédéfini, le procédé comprenant :

l'attribution du nombre de blocs de filtres multidébits dans le système de filtre multidébit ;

le calcul d'une approximation initiale pour un ou plusieurs des blocs de filtres multidébits ;

l'optimisation des blocs de filtres multidébits vers le filtre à large bande pour former un ou plusieurs blocs de filtres multidébits mis à jour ; et

la construction d'un système de filtre multidébit mis en correspondance à partir des blocs de filtres multidébits mis à jour.

15. Le procédé selon la revendication 14, dans lequel l'étape du calcul est effectuée à l'aide d'un algorithme de Parks-McClellan.

16. Le procédé selon la revendication 14 ou 15, dans lequel l'étape d'optimisation est effectuée sur un ou plusieurs sélecteurs de bande et un ou plusieurs combineurs de bandes compris dans le système de filtre multidébit et séparément sur un ou plusieurs des blocs de traitement du signal compris dans le système de filtre multidébit.

17. Le procédé selon l'une quelconque des revendications 14 à 16, comprenant en outre l'ajout d'un bloc de fonctions non linéaires à un ou plusieurs des blocs de filtres multidébits.

18. Le procédé selon la revendication 17, comprenant en outre la configuration du bloc de fonctions non linéaires pour correspondre à une fonction psychoacoustique.

Fig 1

*Fig 2a*

BS_i          220

LP_{i-1} →  ┌─────────┐
            │   HPF   │ ──────────────→ HP_i
            └─────────┘

         ┌─────────┐    ┌─────────┐
         │   LPF   │ →  │  ↓ m   │ ─────→ LP_i
         └─────────┘    └─────────┘

   210      225            230

*Fig 2b*

                245            US_i
S_i →  +  ┌───┐      ┌─────────┐    ┌─────────┐
          │ Σ │ →    │  ↑ k   │ →  │   LPF   │ ──→ SP_i
       +  └───┘      └─────────┘    └─────────┘
                240   250      255        260
SP_{i+1}

*Fig 2c*

                    AP_i
HP_i →  ┌─────────┐    ┌─────────┐
        │  LPB_i  │ →  │  nLB_i  │ ──→ S_i
        └─────────┘    └─────────┘
          270      275        280

*Fig 2d*

                    AP_i        290
HP_i →  ┌─────────┐    ┌─────────┐
        │  FIR_i  │ →  │ COMP_i  │ ──→ S_i
        └─────────┘    └─────────┘
          271      276             ──→ SL_i

*Fig 2e*

                    AP_i        296
HP_i →  ┌─────────┐    ┌─────────┐
        │  aFIR_i │ →  │  LIM_i  │ ──→ S_i
        └─────────┘    └─────────┘
SF_i ─────↑    292        294     ──→ SL_i

*Fig 3*

*Fig 4*

*Fig 5*

example: m=k=r

*Fig 6a*

*Fig 6b*

Define Structure

Define Performance Allowances

Initial Guess

Optimize [iteratively]

Compare

*Fig 7a*

*Fig 7b*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20060109941 A